# EUROPEAN PATENT APPLICATION

(11) **EP 3 128 545 A1**
(43) Date of publication of application: **08.02.2017**
(21) Application number: 15773495.5
(22) Date of filing: 31.03.2015
(51) Int. Cl.: H01L 23/02, H01L 23/06, H01L 23/29, H01L 23/31, H03H 9/25

(54) **CIRCUIT MEMBER HAVING HOLLOW SECTION, MOUNTING STRUCTURE, AND MOUNTING STRUCTURE MANUFACTURING METHOD**

(30) Priority: 31.03.2014 JP 2014073326
(71) Applicant: Nagase ChemteX Corporation, Osaka-shi, Osaka 550-8668 (JP)
(72) Inventor: ISHIBASHI, Takuya, Hyogo 679-4124 (JP); FUJIMOTO, Masatoshi, Hyogo, 679-4124 (JP); HASHIMOTO, Takayuki, Hyogo, 679-4124 (JP)
(74) Representative: von Bülow & Tamada
(86) International application number: PCT/JP2015/001860
(87) International publication number: WO 2015/151514

(57) **Abstract**

A circuit member including: an element having a functional region; a tabular cover disposed opposite to the functional region; and a rib formed to surround the functional region, for providing a space between the functional region and the cover. The cover includes a sheet S having a thickness of 100 µm or less. The sheet S has a tensile elastic modulus Es at 175°C of 10GPa or more. The tensile elastic modulus Es at 175°C of the sheet S is preferably 20GPa or more.

## Description

### [Technical Field]

The present invention relates to a circuit member and a mounting structure, more specifically, to a circuit member and a mounting structure having a hollow space (empty space) inside.

### [Background Art]

In recent years, as the trend toward reduction in size of electronic equipment has continued, there has been demand for reduction in the thickness and size of circuit members to be mounted on electronic equipment as well. SAW chips used for noise reduction in devices such as cellular phones are among such circuit members. SAW chips utilize surface waves that propagate along a piezoelectric substrate (piezoelectric body), to filter the desired frequencies. A space is therefore needed between the electrodes on the piezoelectric body and the circuit board on which the SAW chip is mounted.

In order to ensure a space between the electrodes on the piezoelectric body and the circuit board with the SAW chip mounted thereon, for example, Patent Literatures 1 and 2 disclose a production method of a hollow structure. The method includes forming a rib pattern with a photosensitive resin around the electrodes on the piezoelectric body, and laminating a film of another photosensitive resin onto the rib, to form a cover.

### [Citation List]

### [Patent Literature]

[PTL 1] WO2011/145750
[PTL 2] Japanese Laid-Open Patent Publication No. 2013-178526

### [Summary of Invention]

### [Technical Problem]

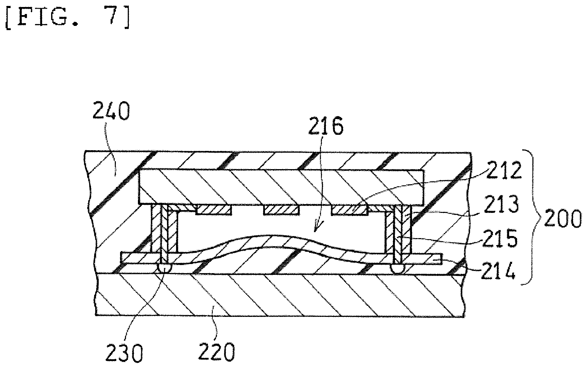

The method disclosed in Patent Literatures 1 and 2 produces a circuit member by providing a rib pattern, between the cover and the piezoelectric body having electrodes thereon, so as to surround the electrodes. As illustrated in FIG. 7, a circuit member 200 is mounted on a wiring board 220 via a plurality of bumps 230. A rib 213 includes a conductor 215 which penetrates there through. Electrodes 212 of the circuit member 200 are electrically connected to the wiring board 220 through the conductors 215 and the bumps 230.

The circuit member 200 mounted on the wiring board 220 is encapsulated with a resin encapsulant 240. For example, in transfer molding, a molding material including a liquefied or softened thermosetting resin is injected into the dies.

The height of the bumps 230 is typically 50 to 60µm. The liquefied or softened molding material goes through between the bumps 230 and enters between a cover 214 of the electronic component 200 and the wiring board 220. At this time, the molding material forces the cover 214 upward. As a result, the cover 214 deforms, which narrows a space 216 between the electrodes 212 and the cover 214 as shown in FIG. 7. When the molding material is cured in this state and forms the resin encapsulant 240, this will interfere with the function of the circuit member. When the pressure applied by the liquefied or softened molding material is large, the cover 214 may break. If the cover 214 breaks, the liquefied or softened molding material will go into the space 216, failing to sufficiently leave the space 216.

Due to the continuing trend toward miniaturization of various electronic equipment including cellular phones and digital cameras, the circuit member 200 itself is required be made thinner. To do this, it is necessary to reduce not only the thickness of the cover 214, but also the height of the space 216. This increases the influence of the deformation of the cover 214on the performance of the circuit member.

### [Solution to Problem]

An object of the present invention is to provide a circuit member and a mounting structure that can maintain a sufficient space between a cover and a functional region.

One aspect of the present invention relates to a circuit member including: an element having a functional region; a tabular cover disposed opposite to the functional region; and a rib formed to surround the functional region, for providing a space between the functional region and the cover. The cover includes a sheet S having a thickness of 100 µm or less. The sheet S has a tensile elastic modulus Es at 175°C of 10 GPa or more.

Another aspect of the present invention relates to a sheet material for forming the above cover.

Still another aspect of the present invention relates a mounting structure including a first circuit member, and a second circuit member mounted on the first circuit member. The second circuit member includes: an element having a functional region; a tabular cover disposed opposite to the functional region; and a rib formed to surround the functional region, for providing a space between the functional region and the cover. The cover includes a sheet S having a thickness of 100 µm or less. The sheet S has a tensile elastic modulus Es at 175°C of 10 GPa or more.

Yet another aspect of the present invention relates a method for producing a mounting structure. The method includes steps of: (i) preparing a first circuit member and a second circuit member, and (ii) mounting the second circuit member on the first circuit member. The second circuit member includes: an element having a functional region; a tabular cover disposed opposite to the functional region; and a rib formed to surround the functional region, for providing a space between the functional region and the cover. The cover includes a sheet S having a thickness of 100 µm or less. The sheet S has a tensile elastic modulus Es at 175°C of 10 GPa or more.

### [Advantageous Effects of Invention]

According to the present invention, even in the case where the circuit member is resin-encapsulated, it is possible to maintain a sufficient space between the cover and the functional region.

### [Brief Description of Drawings]

[FIG. 1A] A cross-sectional view of a circuit member according to one embodiment of the present invention.
[FIG. 1B] A cross-sectional view of a circuit member according to another embodiment of the present invention.
[FIG. 2A] A cross-sectional view of a circuit member according to another embodiment of the present invention.
[FIG. 2B] A cross-sectional view of a circuit member according to another embodiment of the present invention.
[FIG. 2C] A cross-sectional view of a circuit member according to another embodiment of the present invention.
[FIG. 2D] A cross-sectional view of a circuit member according to another embodiment of the present invention.
[FIG. 3] A set of cross-sectional views illustrating a production method of a circuit member according to one embodiment of the present invention.
[FIG. 4A] A cross-sectional view of a mounting structure according to one embodiment of the present invention.
[FIG. 4B] A cross-sectional view of a mounting structure according to another embodiment of the present invention.
[FIG. 5A] A cross-sectional view of a mounting structure according to another embodiment of the present invention.
[FIG. 5B] A cross-sectional view of a mounting structure according to another embodiment of the present invention.
[FIG. 5C] A cross-sectional view of a mounting structure according to another embodiment of the present invention.
[FIG. 5D] A cross-sectional view of a mounting structure according to another embodiment of the present invention.
[FIG. 5E] A cross-sectional view of a mounting structure according to another embodiment of the present invention.
[FIG. 5F] A cross-sectional view of a mounting structure according to another embodiment of the present invention.
[FIG. 5G] A cross-sectional view of a mounting structure according to another embodiment of the present invention.
[FIG. 5H] A cross-sectional view of a mounting structure according to another embodiment of the present invention.
[FIG. 5I] A cross-sectional view of a mounting structure according to another embodiment of the present invention.
[FIG. 5J] A cross-sectional view of a mounting structure according to another embodiment of the present invention.
[FIG. 6] A set of cross-sectional views illustrating a production method of a mounting structure according to one embodiment of the present invention.
[FIG. 7] A cross-sectional view schematically illustrating a conventional circuit member encapsulated with a resin encapsulant.

### [Description of Embodiments]

### [Circuit member]

A circuit member according to the present invention include an element having a functional region, a tabular cover disposed opposite to the functional region, and a rib formed to surround the functional region, for providing a space between the functional region and the cover. The circuit member may be provided with a conductor electrically connected to the element. The cover includes a sheet S having a thickness of 100 µm or less. The sheet S has a tensile elastic modulus Es at 175°C of 10 GPa or more.

The circuit member is, for example, an electronic component having a space inside. Examples of the circuit member include: surface acoustic wave (SAW) chips, bulk acoustic wave (BAW) chips, micro electro mechanical systems (MEMS), and image sensors represented by CMOS sensors and CCD sensors.

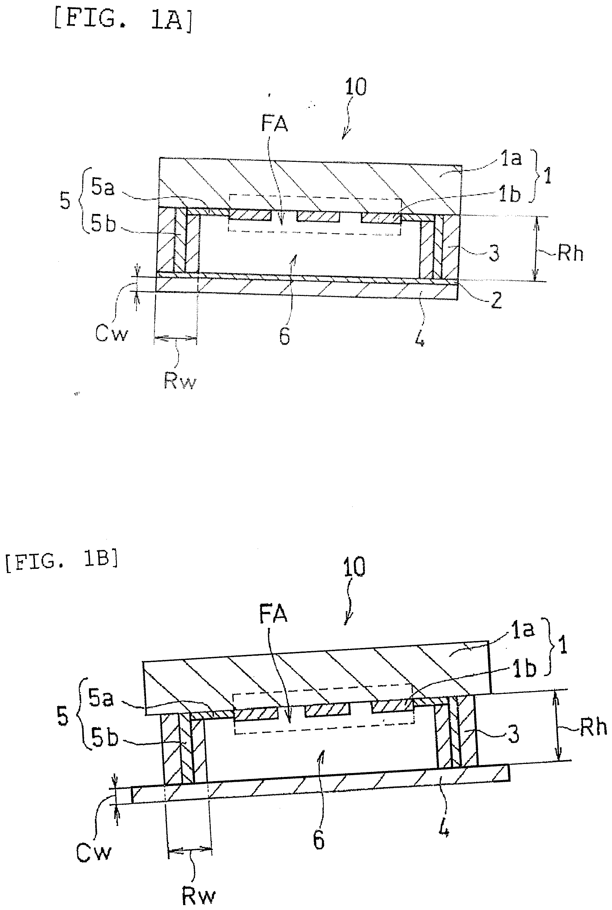

A detailed description of the circuit member is given below by way of an example of a SAW chip, with reference to FIGS. 1A and 1B. FIG. 1B illustrates a modified example of FIG. 1A, which is similar to that illustrated in FIG. 1A except the difference in the presence or absence of an adhesion layer 2, the size of a cover 4 relative to an element 1, and the positional relationship between the element 1 and a rib 3.

A circuit member (SAW chip) 10 includes the element (SAW filter) 1 having a functional region FA (region formed on a piezoelectric body 1a and including at least one interdigitated array electrode 1b consisting of a pair of electrodes), the tabular cover 4 disposed opposite to the functional region FA, and the rib 3 formed to surround the functional region FA, for providing a space 6 between the functional region FA and the cover 4. The circuit member further includes a conductor 5 (5a and 5b) electrically connected to the element 1 (herein, the interdigitated array electrodelb included in the element 1).

When the circuit member is a BAW chip, the element 1 is a BAW filter including a thin film of piezoelectric body (piezoelectric membrane) and two electrodes sandwiching the piezoelectric body from top and bottom sides, and the functional region FA is a region including the electrode on one of the two sides. When the circuit member is an MEMS, the functional region FA can be a region including a cantilever (hammer) or a region including a movable electrode.

### [Element]

The element 1 has a region where its function is exerted (functional region FA). The circuit member 10 provided with such element 1 therefore needs the space 6 in its inside. In other words, the circuit member 10 according to the present invention can be an electronic component having a space inside.

The element 1 having the functional region FA is not limited. Examples thereof include SAW filters, BAW filters, various sensors, machine components, and actuators. The element 1 may be an integrated body of a machine component, sensor, actuator, and the like integrated on one board. Examples of the sensor include an electric magnetic sensor, optical sensor, radiation sensor, and chemical sensor, more specifically, a pH electrode, accelerometer, strain gauge, switch, speaker, laser, and diode. Examples of the machine component include a gear, screw, cam, shaft, spring, coil spring, and lever. The actuator converts energy into physical motion, and mainly includes a driver and a controller. The configuration of the actuator other than this is not limited.

Examples of the material of the piezoelectric body 1a include aluminum nitride, zinc oxide, crystal, lithium compounds such as lithium tantalate, lithium niobate, and lithium tetraborate, gallium arsenic, and lead zirconate titanate. Examples of the material of the interdigitated array electrode 1b and the conductor 5 (5a and 5b) include aluminum, aluminum alloy, copper, silver, nickel, carbon or compounds of these elements, solder, conductive polymers, and mixtures of these materials.

### [Rib]

The rib 3 is formed to surround the functional region FA (herein, interdigitated array electrodes 1b) and provides the space 6 between the functional region FA and the cover 4. The space 6 allows the element 1 to exert its function in the functional region FA. The rib 3 is formed of, for example, a photosensitive resin in a cured state.

The height Rh of the rib 3 (the distance between the surface including the functional region FA of the element 1 and the surface of the cover 4 facing the space 6) is not limited. When the element is a SAW filter, the height Rh of the rib 3 is, for example, preferably 1 to 50µm, more preferably 1 to 30µm, and particularly preferably 1 to 20µm. Setting the height Rh of the rib 3 in this range allows easy production of the circuit member 10. Furthermore, this makes it easy to provide an appropriate space for the element to exert its function, without increasing the size of the circuit member 10.

The width Rw of the rib 3 (the distance between one surface of the rib 3 facing the space 6and the other surface opposite thereto) is not limited. When the element is a SAW filter, the width Rw of the rib 3 is, for example, preferably 1 to 30µm, and more preferably 1 to 20µm. Setting the width Rw of the rib 3 in this range can easily provide sufficient strength for ensuring the space 6, without increasing the size of the circuit member 10.

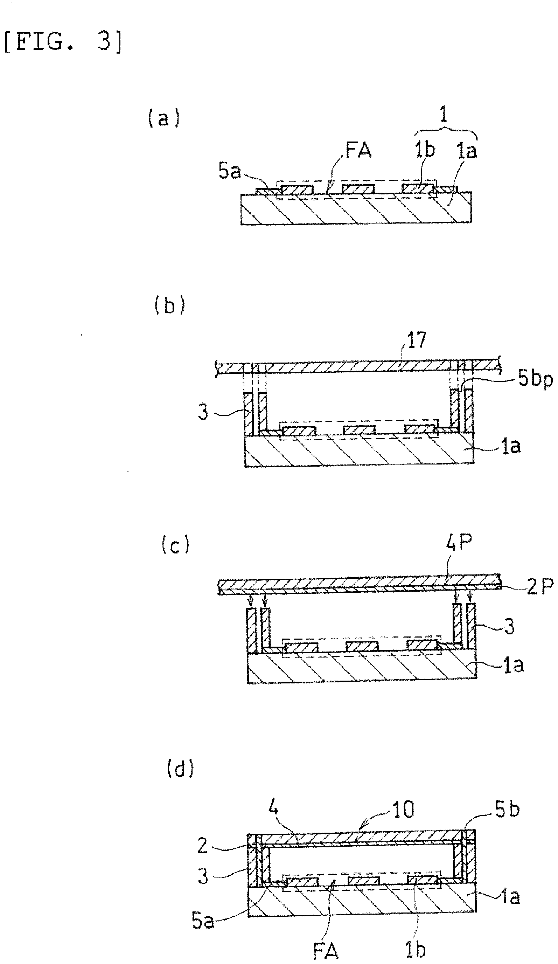

At least part of the abutment surface between the rib 3 and the element 1 and/or at least part of the abutment surface between the rib 3 and the cover 4 may include an adhesion layer A which will be described hereinlater. Alternatively, the rib 3 may have the function of the adhesion layer A. In the latter case, a sheet material on which an adhesion layer AP (2P) is formed in a grid pattern by a method such as screen printing, ink jet printing, or photolithography can be used as a sheet material 4P forming the cover 4 (see FIG. 3(c)). The adhesion layer AP is formed of, for example, an adhesive including a photosensitive resin in an uncured or semi-cured state. The element 1 and the sheet material 4P are joined to each other, with the surface having the adhesion layer AP (2P) of the sheet material 4P facing the functional region FA. The adhesion layer AP is then cured by, for example, irradiation with active light. This joins the element 1 to the cover 4 via the adhesion layer A (2) of a grid pattern, and allows the adhesion layer A (2) to function as the rib 3. Irradiation with active light may be further performed after the element 1 is joined to the cover 4, to facilitate the curing of the photosensitive resin.

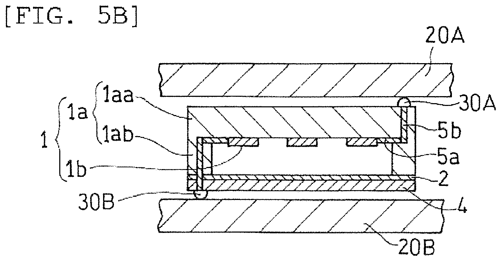

The rib 3 may be formed by cutting or etching the piezoelectric body 1a into a frame shape (see FIGS. 5B to 5E). In this case, the rib 3 is formed of the same material as that of the piezoelectric body 1a. After the rib 3 is formed in a frame shape, the interdigitated array electrodes 1b and the conductors 5a are disposed within the frame.

### [Cover]

The cover 4 is tabular and disposed to face at least the functional region FA that is surrounded by the rib 3. The cover 4 incudes a sheet S. The sheet S has a thickness of 100 µm or less, and a tensile elastic modulus Es at 175°C of 10 GPa or more. In view of the reduction in thickness, the thickness of the sheet S is preferably 50 µm or less, and more preferably 35µm or less. The thickness of the sheet S is preferably 5 µm or more.

The temperature of 175°C is a typical temperature used for resin encapsulation by transfer molding and the like. When the cover 4 includes the sheet S having a tensile elastic modulus Es at 175°C of 10 GPa or more, the cover 4 is less likely to deform in resin encapsulation, leaving a sufficient space as the space 6 between the cover 4 and the functional region FA.

The tensile elastic modulus Es at 175°C of the sheet S (hereinafter simply, "tensile elastic modulus Es") is preferably 20 GPa or more, more preferably 30 GPa or more, and particularly preferably 50 GPa or more. The tensile elastic modulus E is a value measured in accordance with JIS K 7127 (the same applies hereinafter). A tensile tester available from Instron Corporation can be used for the measurement. When the sheet S contains a photosensitive resin and/or thermosetting resin, the tensile elastic modulus Es represents a physical property value of the sheet S containing the photosensitive resin and/or thermosetting resin in a cured state.

The tensile elastic modulus Es can be set as appropriate to be 10 GPa or more, depending on an area S of a portion encircled by the rib 3 (hereinafter simply, "area S"). When the area S is large, the tensile elastic modulus Es is preferred to be high; when the area S is small, the tensile elastic modulus Es may be comparatively low. In other words, the area S and the tensile elastic modulus Es are in a proportional relationship. For example, when the area S is less than 0.2 mm², it suffices if the tensile elastic modulus Es is 10 GPa or more; when the area is 0.2 mm² or more and less than 4 mm², the tensile elastic modulus Es is preferably 20 GPa or more; when the area S is 4 mm² or more, the tensile elastic modulus Es is preferably 30 GPa or more.

Examples of the material of the sheet S include resin, ceramics, silicon, glass, fiber-reinforced resin, and metal. The material of the sheet S is preferably at least one selected from the group consisting of ceramics, silicon, glass, fiber-reinforced resin, and metal, and more preferably, glass or fiber-reinforced resin, because of their higher tensile elastic modulus Es. A preferred fiber-reinforced resin is a glass fiber-reinforced resin (GFRP).

Examples of the ceramics used for the sheet S include alumina, aluminum nitride, silicon nitride, silicon nitride, boron nitride, and zirconia.

Examples of the metal used for the sheet S include aluminum, copper, stainless steel, iron, and organic substances with these metals vapor-deposited or plated thereon. When a metal plate is used as the sheet S, the cover 4 can be made electrically insulative by, for example, coating the metal plate with an insulative material (e.g., a ceramics material such as alumina or boron nitride, an insulating organic material). An insulating organic material may be used as the below-described adhesion layer A, so that the cover 4 can be made electrically insulative.

The resin used for the sheet S is, for example, a photosensitive resin, a thermoplastic resin, or a thermosetting resin. The fiber-reinforced resin contains, for example, the above resin and a high-modulus fiber (e.g., aramid fiber, glass fiber, fluorine containing fiber, polyimide fiber, carbon fiber, polyphenylene sulfide fiber).

The high-modulus fiber used for the fiber-reinforced resin may be either short or long fibers. The high-modulus fiber may be made into a woven or knitted fabric. The fiber-reinforced resin can be obtained by applying pretreatment to the high-modulus fiber, if necessary, and then allowing a photosensitive, thermoplastic or thermosetting resin to be impregnated between the high-modulus fibers. In view of the adhesiveness between the cover 4 and the rib 3 (or, the adhesion layer A when the cover 4 includes the adhesion layer A, as described hereinlater), the fiber-reinforced resin preferably contains an epoxy resin composition.

The thermoplastic resin can be a so-called engineering plastic, which is excellent in heat resistance. Examples of the engineering plastic include polyimide, polyamide, polycarbonate, and liquid crystal polymers such as aromatic polyester.

The photosensitive resin can be any resin that is cured by light energy. Examples thereof include acrylate compounds, methacrylate compounds, and photopolymers such as photosensitive polyimide resin.

The thermosetting resin is not limited, and can contain, as a base resin, an epoxy resin, polyimide, phenol resin, silicone resin, melamine resin, urea resin, alkyd resin, polyurethane, unsaturated polyester, and the like. Preferred among them is an epoxy resin, because of its excellent elastic modulus. These may be used singly or in combination of two or more.

The thermosetting resin is typically used in the form of a compound. The compound can contain a thermosetting resin, a curing agent, a curing accelerator, a solvent, and the like. For example, an epoxy resin compound can be obtained by blending an epoxy resin with: a curing agent, such as phenol resin, acid anhydride, amine compound, and dicyandiamide; a curing accelerator, such as imidazole-based accelerator, phosphorous-based accelerator, phosphonium salt-based accelerator, bicyclic amidines and derivatives thereof, organometallic complex, and urea compound of polyamine; and a solvent, such as ethers including diethyl ether, diisopropyl ether, and tetrahydrofuran.

The epoxy resin is not limited, and examples thereof include bisphenol A-type epoxy resin, bisphenol F-type epoxy resin, bisphenol AD-type epoxy resin, naphthalene-type epoxy resin, biphenyl-type epoxy resin, glycidylamine-type epoxy resin, cycloaliphatic epoxy resin, dicyclopentadiene-type epoxy resin, novolac-type epoxy resin, polyether-type epoxy resin, and silicone-modified epoxy resin. These may be used singly or in combination of two or more. Preferred among them are naphthalene-type epoxy resin, bisphenol A-type epoxy resin, bisphenol F-type epoxy resin, and bisphenol AD-type epoxy resin. More preferred among them are bisphenol A-type epoxy resin, bisphenol F-type epoxy resin, and naphthalene-type epoxy resin.

The phenol resin is not limited, but is preferably a novolac resin. The novolac resin is a condensation polymer of phenols or naphthols (e.g., phenol, cresol, naphthol, alkyl phenol, bisphenol, terpene phenol), and formic aldehyde. More specific examples thereof include phenol novolac resin, cresol novolac resin, bisphenol A novolac resin, aralkyl phenol novolac resin, biphenyl phenol novolac resin, terpene phenol novolac resin, α-naphthol novolac resin, and β-naphthol novolac resin. These may be used singly or in combination of two or more.

The cover 4 may comprise a stack of the sheet S and another material (e.g., a material having a tensile elastic modulus E at 175°C (hereinafter simply, "tensile elastic modulus E") of less than 10 GPa (e.g., 10 MPa or more and less than 5,000 MPa). The another material may be a sheet-like material. The sheet-like material having a tensile elastic modulus E of less than 10 GPa is not limited, and is, for example, a resin plate containing a photosensitive, thermoplastic or thermosetting resin as described above.

The cover 4 comprises, for example, one layer (one piece) of the sheet S, such as glass fiber-reinforced resin plate (sheet S), glass plate (sheet S) or metal plate (sheet S). The cover 4 may comprise a stack of a plurality of the sheets S. Examples of such cover 4 include a stack of two glass fiber-reinforced resin plates (sheets S), a stack of a glass plate (sheet S) and a resin plate, a stack of two glass plates (sheets S) with a resin plate interposed therebetween, a stack of a metal plate (sheet S) and a resin plate, a stack of two metal plates (sheets S) with a resin plate interposed therebetween, a stack of a glass plate (sheet S) and a metal plate (sheet S) with a resin plate interposed therebetween.

The principal surface of the cover 4 is only required to be the same as or larger than the area S encircled by the rib 3, and not limited to any particular size. The thickness Cw of the cover 4 (the distance between two principal surfaces opposite to each other) is preferably spam to 3mm, more preferably 5µm to 500µm, and more preferably 5 to 400µm. When the element 1 is a SAW filter, the thickness Cw of the cover 4 may be, for example, be 5 to 100µm. With the thickness Cw of the cover 4 in this range, the thickness of the circuit member can be easily reduced, and the cover 4 can be made less likely to deform in the below-described encapsulating process.

### [Adhesion layer]

The element 1 and/or the cover 4 preferably adheres to the rib 3 without any gap in between for ensuring the space 6. It is therefore preferable that the adhesion layer A (2) is provided on at least part of an abutment surface between the element 1 and the rib 3 and/or on at least part of an abutment surface between the cover 4 and the rib 3. When the rib 3 is formed of an adhesive material (e.g., a photosensitive resin in an uncured or semi-cured state), since the rib 3 functions as the adhesion layer, the circuit member 10 may not additionally include the adhesion layer A.

The adhesive forming the adhesion layer A is, for example, the above-mentioned thermosetting resin in an uncured or semi-cured state, but not limited thereto. In view of the adhesiveness, the adhesive forming the adhesion layer A preferably contains an epoxy resin composition. In particular, in view of the adhesiveness between the cover 4 and the rib 3, both the cover 4 and the adhesion layer A preferably contain an epoxy resin composition in a cured state. It is to be noted that when the adhesion layer A contains a thermosetting resin, the physical property values below are those of the adhesion layer A containing the thermosetting resin in a cured state.

The adhesion layer A preferably has a tensile elastic modulus Ea at 175°C (hereinafter simply, "tensile elastic modulus Ea") of 10 MPa or more, and more preferably 100 MPa or more. This is preferable because, in the resin encapsulation of the circuit member 10, the deformation of the adhesion layer can be reduced, and the positional displacement of the cover 4 can be suppressed. The tensile elastic modulus Ea is not limited, and may be lower than the tensile elastic modulus Es of the sheet S. For example, the tensile elastic modulus Ea may be less than 20GPa, less than 10GPa, or less than 5GPa. In view of the handleability, the adhesion layer A preferably has a tensile elastic modulus Ea' at room temperature of 1 to 20GPa.

The adhesion layer A preferably has a glass transition temperature Tga of 80°C or more, more preferably 120°C or more, and particularly preferably equal to or higher than a temperature applied in the resin encapsulation (e.g., 175°C or more). This is preferable because the decrease in the elastic modulus can be suppressed, and the positional displacement of the cover 4 can be more effectively suppressed. The glass transition temperature Tga is a value measured by DMA method at a temperature elevation rate of 2°C/min and a frequency of 1Hz (the same applies hereinafter).

When the adhesion layer A is provided on at least part of the abutment surface between the cover 4 and the rib 3, under a temperature condition equal to or lower than the glass transition temperature Tga of the adhesion layer A, the adhesion layer A preferably has a linear expansion coefficient CTEa of 60ppm/°C or less, and more preferably 50ppm/°C or less. The linear expansion coefficient CTEa of the adhesion layer A may be 1ppm/°C or more, 10ppm/°C or more, or 20ppm/°C or more.

In the case above, under the temperature condition equal to or lower than the glass transition temperature Tga of the adhesion layer A, the difference between the linear expansion coefficient CTEa and a linear expansion coefficient CTEs of the sheet S is preferably 50 ppm/°C or less, more preferably 40ppm/°C or less, and particularly preferably 30ppm/°C or less. The difference between the linear expansion coefficients CTEa and CTEs is preferably as small as possible, but may be, for example, 1ppm/°C or more, or 10ppm/°C or more. When the linear expansion coefficient CTEa satisfies the above range, in resin encapsulation and mounting of the circuit member 10, the adhesion failure (e.g., cracks, separation) and warpage of the cover 4 are less likely to occur, and this can favorably maintain the space 6 in the circuit member 10. Under the temperature condition equal to or lower than the glass transition temperature Tga of the adhesion layer A, the linear expansion coefficient CTEs of the sheet S is, for example, 1 to 30ppm/°C.

When the adhesion layer A is provided on at least part of the abutment surface between the cover 4 and the rib 3, in view of the adhesiveness, under the temperature condition equal to or lower than the glass transition temperature Tga of the adhesion layer A, the linear expansion coefficient CTEa of the adhesion layer A preferably falls between the linear expansion coefficient CTEs of the sheet S and a linear expansion coefficient CTEr of the rib 3 (CTEr>CTEa>CTEs). The linear expansion coefficient CTEr of the rib 3 is, for example, 20 to 60ppm/°C.

The linear expansion coefficient CTE can be measured with a thermomechanic analyzer complying with JIS K7197. More specifically, the linear expansion coefficient CTE can be measured using a test piece of 2mm ×5mm ×20mm, with a thermomechanic analyzer (e.g., TMA7100 available from Hitachi High-Tech Science Corporation), in the compression mode, at a temperature elevation rate of 2.5°C/min, and under a load of 49mN.

In view of the adhesiveness and reduction in thickness, the thickness of the adhesion layer A is preferably, for example, 100 µm or less. In particular, the thickness of the adhesion layer A is preferably 0.1µm to 50µm, more preferably 1µm to 30µm, and more preferably 3µm to 20µm. In view of suppressing the deformation of the cover 4, a ratio of the thickness of the sheet S to that of the adhesion layer A (2) (sheet S / adhesion layer A) is preferably 0.1 to 1000, preferably 0.2 to 100, and particularly preferably 0.5 to 10.

### [Conductor]

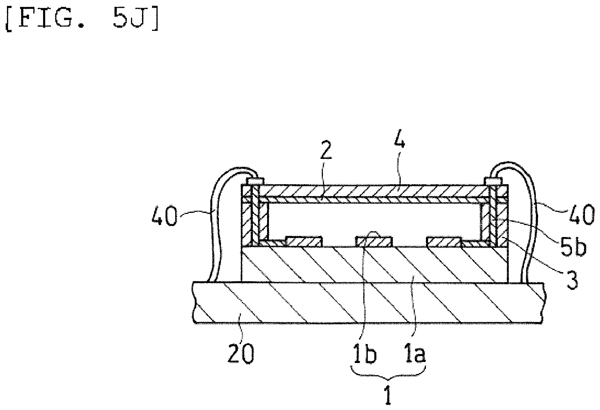

The conductor 5 (5a and 5b) is electrically connected to the element 1 (here, the interdigitated array electrode 1b included in the element 1). The conductor 5, as described hereinlater, is electrically connected also to a first circuit member 20, via a bump 30 and a bonding wire 40 (see FIGS. 5I and 5J).

The conductor 5 (5a and 5b) is formed of, for example, an electrically conductive material such as conductive paste or metal particles. The conductor 5b penetrates through the rib 3 in FIG. 1, but not limited thereto, and may be provided on the surface facing the space 6 of the rib 3, or on the surface not facing the space 6 of the rib 3. The conductor 5b may penetrate through the element 1, and may penetrate through the cover 4 (see, e.g., FIG. 5B).

### [Tape material]

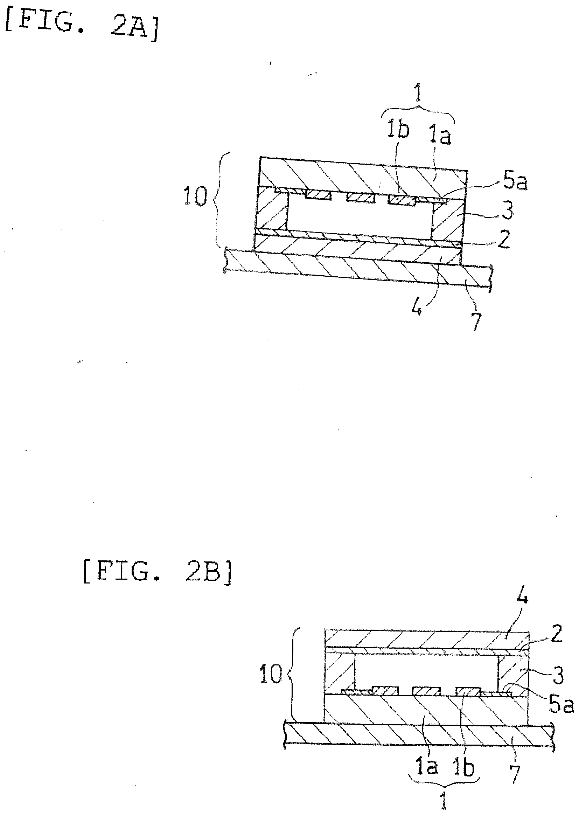

As illustrated in FIG. 2A, the circuit member 10 may be affixed to a tape material 7. The tape material 7 is used for temporarily fixing the circuit member 10 until, for example, it is mounted on the below-described first circuit member.

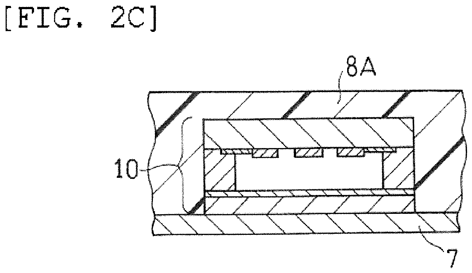

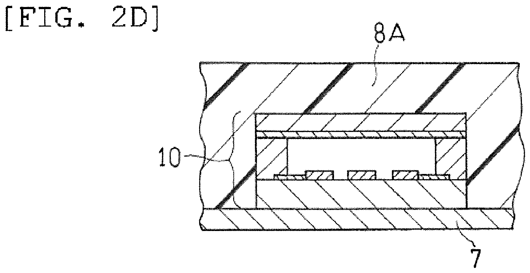

An embodiment using the tape material 7 is as follows. First, a plurality of the circuit members 10 are affixed to the tape material 7, and the circuit members 10 are encapsulated with, for example, a resin encapsulant 8A which will be described hereinlater (see FIGS. 2C and 2D). Next, the resin encapsulant 8A on the surface of the circuit members 10 is removed as necessary, to expose the piezoelectric body 1a and/or the cover 4. This is followed by dicing, thereby to singulate the resin-encapsulated circuit members 10. The singulated circuit member 10 is mounted on the first circuit member. When mounting the circuit member 10 on the first circuit member, the circuit member 10 is separated from the tape material 10. The separation from the tape material 7 may be done, for example, after the circuit member 10 is resin-encapsulated, or after the piezoelectric body 1a and/or the cover 4 is exposed, or after dicing.

The tape material 7 may be in any form, and for example, may be a laminate of a base material sheet and a sticky layer. The sticky layer preferably comprises a sticky component whose stickiness will be reduced by heating or ultraviolet irradiation. Examples of the tape material 7 include REVALPHA (registered trademark) available from Nitto Denko Corporation, and PROSS WELL (registered trademark) available from Nitto Denko Corporation. The cover 4 of the circuit member 10 is affixed to the tape material 7 in FIG. 2A, but not limited thereto. For example, as in FIG. 2B, the element 1 may be affixed to the tape material 7.

### [Resin encapsulant]

The circuit member 10 may be encapsulated with the resin encapsulant 8A. FIGS. 2C and 2D illustrate an embodiment in which the circuit member 10 is affixed to the tape material 7 and encapsulated with the resin encapsulant 8A.

The resin encapsulant 8A is not limited, and is, for example, a cured product of a composition containing a thermosetting resin, curing agent, curing accelerator, inorganic filler, and the like. There is no limitation on the thermosetting resin, curing agent, and curing accelerator, and examples thereof are as those described above. Examples of the inorganic filler include fused silica, crystal silica, alumina, magnesium oxide, and silicon nitride.

The encapsulation method using the resin encapsulant 8A is not limited. For example, the resin encapsulant 8A in an uncured or semi-cured state is disposed around the circuit member 10 by, for example, transfer molding, compression molding, screen printing, underfilling, potting, and dip coating. Preferred among them is compression molding. In underfilling, the resin encapsulant 8A in an uncured or semi-cured state molded in a sheet or other similar shapes can be used.

### [Sheet material]

A sheet material 4P according to the present invention is a sheet material for forming the cover 4. More specifically, the sheet material 4P includes a sheet SP as a precursor of the sheet S, and has a similar composition to the cover 4. When the sheet S contains a thermosetting resin and/or photosensitive resin, the sheet SP may contain the thermosetting resin and/or photosensitive resin in an uncured or semi-cured state. The sheet material 4P containing a thermosetting resin and/or photosensitive resin in an uncured or semi-cured state is, for example, cured by heating or irradiation with active light after placed on an end of the rib 3, thereby forming the cover 4.

The sheet material 4P, in view of the reinforcement, may contain a thermosetting resin and/or photosensitive resin in a cured state. The sheet material 4P, in view of the adhesiveness to the rib 3 or the like, may contain a thermosetting resin and/or photosensitive resin in an uncured or semi-cured state.

The sheet material 4P may include the adhesion layer AP. The adhesion layer AP forms the adhesion layer A in the circuit member 10. In other words, the adhesion layer AP can contain a thermosetting resin in an uncured or semi-cured state. The "semi-cured state" refers to a state where the resin is not cured totally but has lost its fluidity.

When the adhesion layer AP contains a thermosetting resin in an uncured or semi-cured state, under a temperature condition equal to or higher than room temperature (e.g., 20°C) and equal to or lower than a curing temperature of the adhesion layer AP, the adhesion layer AP preferably has a storage shear modulus Ga' of 0.05 to 10 MPa. Under the same temperature condition, a ratio: Ga"/Ga' of a loss shear modulus Ga" of the adhesion layer AP to the storage shear modulus Ga' is preferably 0.1 to 2.0.

Preferably, the storage shear modulus Ga' and the loss shear modulus Ga" satisfy the above range under a temperature condition from (room temperature + 20°C) to (curing temperature of the adhesion layer AP - 20°C). This is preferable because the dripping or bleeding of the adhesion layer AP is suppressed, and the adhesion to the rib 3 or the element 1 can be facilitated. The above temperature condition may be, for example, from 50 to 120°C.

Particular preferably, under a temperature condition equal to or higher than a temperature at which the adhesion layer AP exerts its adhesiveness or tackiness (instantaneous adhesiveness of the adhesive), specifically under a temperature condition under which the sheet material 4P adheres to the rib 3 or the element 1 (at the adhesion temperature), the storage shear modulus Ga' of the adhesion layer AP and the Ga"/Ga' are within the ranges above. This can more effectively suppress the dripping or bleeding of the adhesion layer AP.

In view of suppressing the dripping or bleeding of the adhesion layer AP and facilitating the adhesion, the storage shear modulus Ga' of the adhesion layer AP under the temperature conditions above is more preferably 0.1 to 5MPa. The Ga"/Ga' is more preferably 0.2 to 1.9, and particularly preferably 0.3 to 1.8.

The storage shear modulus Ga' and the loss shear modulus Ga" can be measured with a viscoelastometer complying with JIS K 7244. More specifically, the storage shear modulus Ga' and the loss shear modulus Ga" can be measured using a test piece of 8mm in diameter × 1mm, with a viscoelastometer (e.g., ARES-LS2 available from TA Instruments Corporation), at a frequency of 1Hz and a temperature elevation rate of 10°C/min.

The adhesion layer AP comprises a composition containing a thermosetting resin, curing agent, curing accelerator, inorganic filler, and the like. The inorganic filler, in view of suppressing the ductile deformation of the adhesion layer AP, preferably has a particle diameter D95 at 95% cumulative volume (hereinafter, "particle diameter D95") is smaller than the thickness of the adhesion layer, and has an average particle diameter D50 of equal to or less than 1/3 of the thickness of the adhesion layer. The inorganic filler is preferably blended in an amount of 2 to 2000 parts by mass, relative to 100 parts by mass of the thermosetting resin. The average particle diameter D50 is a median diameter in a volumetric particle size distribution measured with a particle size distribution analyzer by dynamic light scattering method. The particle diameter D95 is a particle diameter when the accumulation percentage reaches 95 vol% in a volumetric particle size distribution measured with a particle size distribution analyzer by dynamic light scattering method.

For example, when the film thickness of the adhesion layer AP is 10µm, in view of increasing the transparency of the composition, the inorganic filler preferably has a particle diameter D95 of 3.0µm or less and an average particle diameter D50 of 1µm or less, and is preferably blended in an amount of 2 to 600 parts by mass, relative to 100 parts by mass of the thermosetting resin. When the sheet material 4P comprising the adhesion layer AP made of the composition as above and a transparent glass plate (sheet S) is used to form the cover, the internal structure of the circuit member can be visually inspected through the sheet material 4P, and further through the cover 4.

For example, in the method for producing the circuit member 10, in the case of forming the conductor 5b that penetrates through the cover 4, after the sheet material 4P is placed to form the cover 4, a cavity 5bₚ for forming the conductor 5b is formed from one principal surface of the cover 4, by laser irradiation or the like. At this time, the position adjustment is carried out by utilizing, for example, an alignment mark provided on the element 1 or the rib 3. When the transparency of the cover 4 is high, the alignment mark can be clearly recognized from outside the circuit member 10, and therefore, the cavity 5bₚ can be formed with high positional precision.

### [Method for producing circuit member]

A method for producing the circuit member 10 is described below by way of an example of a SAW chip, with reference to FIG. 3.

As illustrated in FIG. 3(a), the element 1 (SAW filter) including the functional region FA (region formed on the piezoelectric body 1a and including at least one interdigitated array electrode 1b consisting of a pair of electrodes) is prepared. The element 1 is provided with the conductor 5a. The conductor 5a is electrically connected to the element 1 (here, the interdigitated array electrode 1b included in the element 1).

On the surface of the piezoelectric body 1a on which the interdigitated array electrodes 1b are provided, the adhesion layer AP may be formed at a portion to abut against at least the rib 3, by a method such as screen printing, ink jet printing, or photolithography. The adhesion layer AP may be directly formed on the element 1 by the foregoing method, or may be formed by attaching a sheet on the element 1, the sheet including the adhesion layer AP and molded in a corresponding shape. The method for forming the adhesion layer AP on at least part of the abutment surface between the element 1 and the rib 3 is not limited thereto. In another method, the sheet material 4P may be formed to include a precursor of the rib 3 and the adhesive layer AP, and the sheet material 4P thus formed can be used to form the cover 4. This method will be described hereinlater.

Next, the rib 3 is formed to surround the functional region FA, on the element 1 (see FIG. 3(b)). In FIG. 3(b), the rib 3 is partially on the conductor 5a. In this case, the below-described conductor 5b is formed to penetrate through the rib 3, or formed on the surface facing the space 6of the rib 3. It is to be noted that the conductor 5b is formed to penetrate through the rib 3 in the present embodiment, but not limited thereto.

The rib 3 can be formed by, for example, applying a photosensitive resin or laminating a photosensitive resin film onto the surface including the function region FA of the element 1, and after applying a mask as necessary, irradiating them with active light to cure the exposed portion. In this case, for example, by using a mask 17 as shown in FIG. 3(b), the cavity 5bₚ for forming the conductor 5b penetrating through the rib 3 may be formed at the same time.

The rib 3 may be formed by cutting the piezoelectric body 1a into a frame shape. In this case, after the rib 3 is formed in a frame shape, the interdigitated array electrodes 1b and the conductors 5a are disposed within the frame.

The rib 3 may be formed of the adhesion layer A. In this case, the rib 3 is formed in the subsequent step of placing the sheet material 4P. More specifically, the sheet material 4P including the adhesion layer AP formed in a grid pattern is used, and the element 1 and the sheet material 4P are joined to each other, with the surface having the adhesion layer AP of the sheet material 4P facing the functional region FA. This is followed by curing as necessary, thereby to form the rib 3 comprising the adhesion layer A. In these cases, the cavity 5bₚ can be formed by making a hole in the rib 3 by, for example, irradiation with laser light. The formation of the cavity 5bₚ may be carried out after the subsequent step of placing the sheet material 4P.

The rib 3 and the adhesion layer A (not shown) may be formed in the subsequent step of placing the sheet material 4P. The adhesion layer A is formed on at least part of the abutment surface between the rib 3 and the element 1. The sheet material 4P used in this case includes: a precursor of the rib 3 formed of a photosensitive resin or the like in a grid pattern; and the adhesion layer AP formed on a portion of the end surface of the precursor of the rib 3, the portion to be abut against the element 1. The sheet material 4P is placed on the element 1, with the surface having the adhesion layer AP facing the functional region FA, and then, the element 1 and the rib 3 are joined to each other via the adhesion layer AP. This is followed by curing as necessary, thereby to complete the rib 3, and the adhesion layer A formed on at least part of the abutment surface between the rib 3 and the element 1. The subsequent steps are similar to the above.

Next, the sheet material 4P for forming the cover 4 is placed so as to completely cover the other end of the rib 3 opposite to the end thereof joined to the element 1 (FIG. 3(c)). When the sheet material 4P has the adhesion layer AP (2P), the sheet material 4P is placed on the end of the rib 3, with the surface having the adhesive layer AP (2P) of the sheet material 4P facing the end of the rib 3. Subsequently, an electrically conductive material is injected into the cavity 5bₚ, to form the conductor 5b. Lastly, the cover 4 is cut in a desired shape, and the circuit member 10 can be obtained (FIG. 3(d)).

When the sheet material 4P includes the sheet SP containing a photosensitive resin, the cover 4 can be formed by placing the sheet material 4P on the end of the rib 3, and after applying a mask as necessary, irradiating them with active light for curing. When the sheet material 4P includes the sheet SP containing a thermosetting resin, the cover 4 can be formed by placing the sheet material 4P on the end of the rib 3, and heating them for curing and adhesion.

The circuit member 10 may be encapsulated with the resin encapsulant 8A. The encapsulation method is not limited, and examples thereof are as described above.

### [Mounting structure]

The mounting structure of the present invention includes a first circuit member and a second circuit member mounted on the first circuit member.

The first circuit member is, for example, at least one selected from the group consisting of a semiconductor device, a semiconductor package, a glass board, a resin board, a ceramic board, and a silicon board. The first circuit member may include an electrically conductive material layer, such as anisotroic electrical conduction film (ACF) or anisotropic conductive paste (ACP), on its surface. The resin board may be a rigid or flexible resin board, and examples thereof include an epoxy resin board (e.g., glass epoxy board), bismaleimide-triazine board, polyimide resin board, and fluorocarbon resin board. The first circuit member may be an electronic component built-in board with a semiconductor chip and the like incorporated therein. The second circuit member is, for example, the above circuit member 10.

More specifically, the mounting structure can have a chip-on-board (CoB) structure (including chip-on-wafer (CoW), chip-on-film (CoF), and chip-on-glass (CoG)), chip-on-chip (CoC) structure, chip-on-package (CoP) structure, and package-on-package (PoP) structure, in which the second circuit member is mounted on various kinds of first circuit members. The mounting structure may be a multilayer mounting structure in which the first circuit member and/or second circuit member is mounted on the first circuit member with the second circuit member mounted thereon.

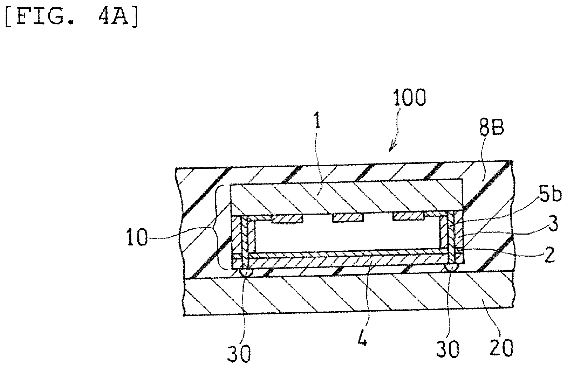

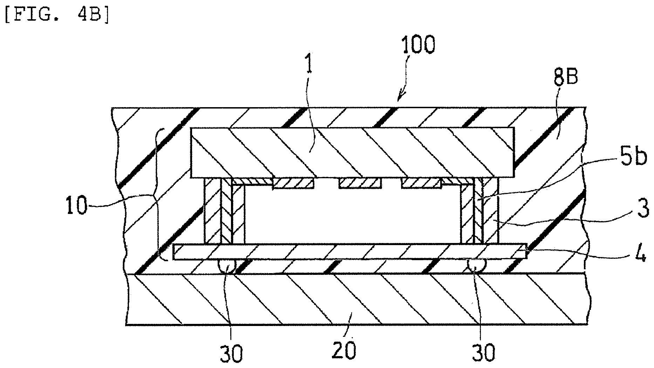

FIGS. 4A and 4B illustrate one embodiment of the mounting structure. In FIG. 4A, the cover 4 is joined to the first circuit member 20, via the bumps 30 electrically connected to the conductors 5b penetrating through the rib 3. The second circuit member (circuit member 10) is thereby mounted on the first circuit member 20. FIG. 4B illustrates a modified example of FIG. 4A, which is similar to that illustrated in FIG. 4A except the difference in the presence or absence of the adhesion layer 2, the size of the cover 4 relative to the element 1, and the positional relationship between the element 1 and the rib 3.

A mounting structure 100 may include a resin encapsulant 8B encapsulating the circuit member 10 and filling the gap between the cover 4 and the first circuit member 20. Examples of the resin encapsulant 8B are the same as or similar to those of the resin encapsulant 8A. The circuit member 10 may be further encapsulated with the resin encapsulant 8B after the circuit member 10 encapsulated with the resin encapsulant 8A is mounted on the first circuit member 20.

The height of the bump 30 is, for example, 40 to 70µm. The material of the bump 30 is, for example, a solder ball. The bump 30 may be placed in any position where it is electrically connected to the conductor 5.

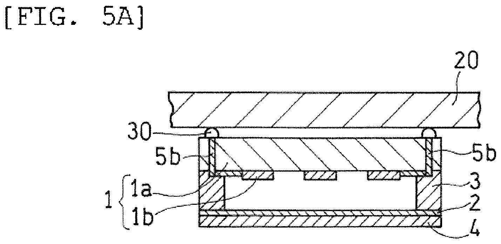

The configuration of the mounting structure 100 is not limited thereto, and the mounting structure 100may be configured as illustrated in FIGS. 5A to 5J. More specifically, in FIG. 5A, the element 1 (piezoelectric body 1a) is provided with the conductors 5b. The circuit member 10 is mounted on the first circuit member 20 by being joined to the first circuit member 20 via the bumps 30 electrically connected to the conductors 5b penetrating through the element 1.

In FIG. 5B, the rib is formed by cutting or etching the element 1 (piezoelectric body 1a). The element 1 includes a rib portion 1ab and a main portion 1aa each provided with the conductor 5b. The circuit member 10 is mounted on a first circuit member 20A via a bump 30A electrically connected to the conductor 5b penetrating through the main portion 1aa of the element 1, and mounted on a first circuit member 20B via a bump 30B electrically connected to the conductor 5b penetrating through the rib portion 1ab.

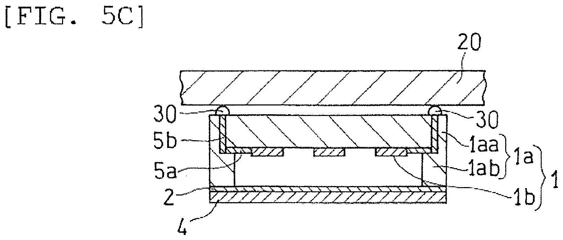

In FIG. 5C, like in FIG. 5B, the rib is formed by cutting or etching the element 1 (piezoelectric body 1a). The circuit member 10 is mounted on the first circuit member 20 via the bumps 30 electrically connected to the conductors 5b penetrating through the main portion 1aa of the element 1.

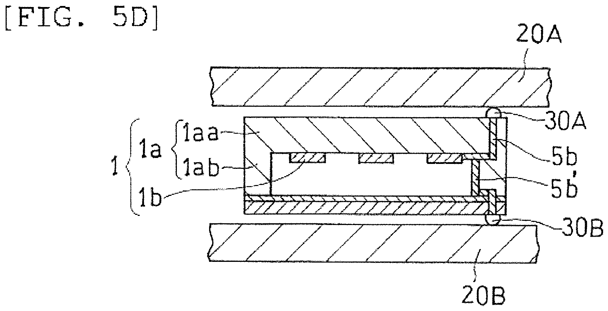

In FIG. 5D, like in FIG. 5B, the rib is formed by cutting or etching the element 1 (piezoelectric body 1a). The circuit member 10 is mounted on the first circuit member 20A via the bump 30A which is electrically connected to one electrodelbof the interdigitated array electrode, through the conductor 5b. Furthermore, the circuit member 10 is mounted on the first circuit member 20B via the bump 30B which is electrically connected to the other electrode 1b' (not shown) of the interdigitated array electrode, through a conductor 5b'. In the illustrated example, the conductor 5b is formed to penetrate through the main portion 1aa, while the conductor 5b' is formed to extend along the surface facing the space 6 of the rib portion 1ab.

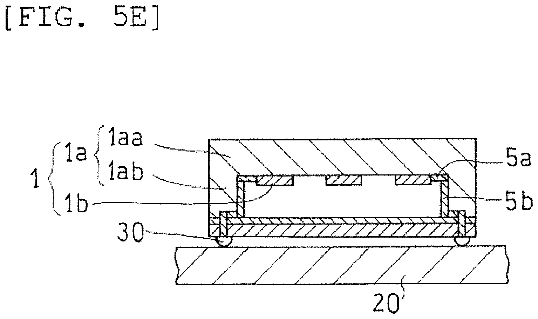

In FIG. 5E, like in FIG. 5B, the rib is formed by cutting or etching the element 1 (piezoelectric body 1a). The circuit member 10 is provided with the conductors 5b each having a portion extending along the surface facing the space 6 of the rib portion 1ab and a portion penetrating through the cover 4. The circuit member 10 is mounted on the first circuit member 20 via the bumps 30 electrically connected to the conductors 5b.

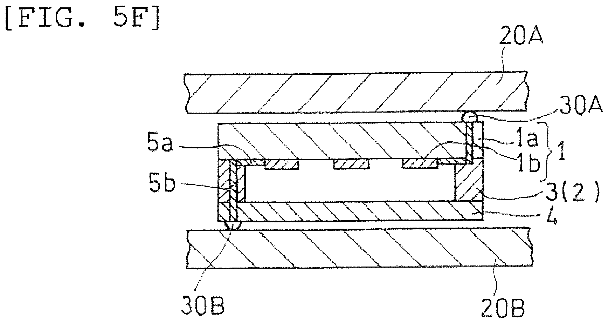

In FIG. 5F, the rib 3 is formed of the adhesion layer A (2), and the element 1 (piezoelectric body 1a) and the rib 3 formed of the adhesion layer A (2) are both provided with the conductor 5b. The circuit member 10 is mounted on the first circuit member 20A via the bump 30A electrically connected to the conductor 5b penetrating through the element 1, and mounted on the second circuit member 20B via the bump 30B electrically connected to the conductor 5b penetrating through the adhesion layer A (2).

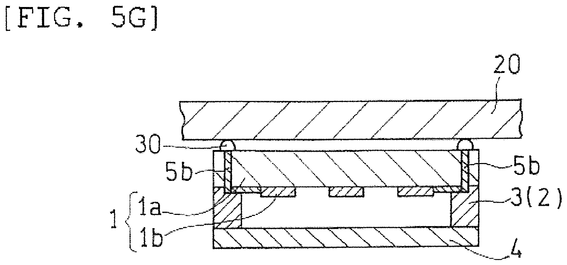

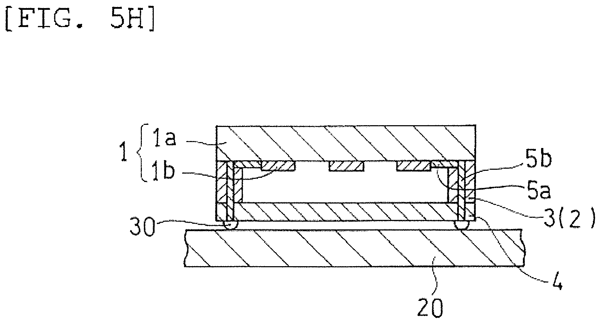

In FIGS. 5G and 5H, like in FIG. 5F, the rib 3 is formed of the adhesion layer A (2). In FIG. 5G, the circuit member 10 is mounted on the first circuit member 20 via the bumps 30 electrically connected to the conductors 5b penetrating through the element 1 (piezoelectric body 1a). In FIG. 5H, the circuit member 10 is mounted on the first circuit member 20 via the bumps 30 electrically connected to the conductors 5b penetrating through the adhesion layer A (2).

In FIGS. 5I and 5J, the bumps 30 are replaced with bonding wires 40 to connect the circuit member 10 to the first circuit member 20. In FIG. 5I, the element 1 (piezoelectric body 1a) is provided with the conductor 5b; in FIG. 5J, the rib 3 is provided with the conductor 5b. The bumps 30 and the bonding wires 40 may be replaced with ACF or ACP to connect the circuit member 10 to the first circuit member 20. The circuit member 10 of FIGS. 5A to 5J may be encapsulated with the resin encapsulant 8A and/or 8B.

### [Method for producing mounting structure]

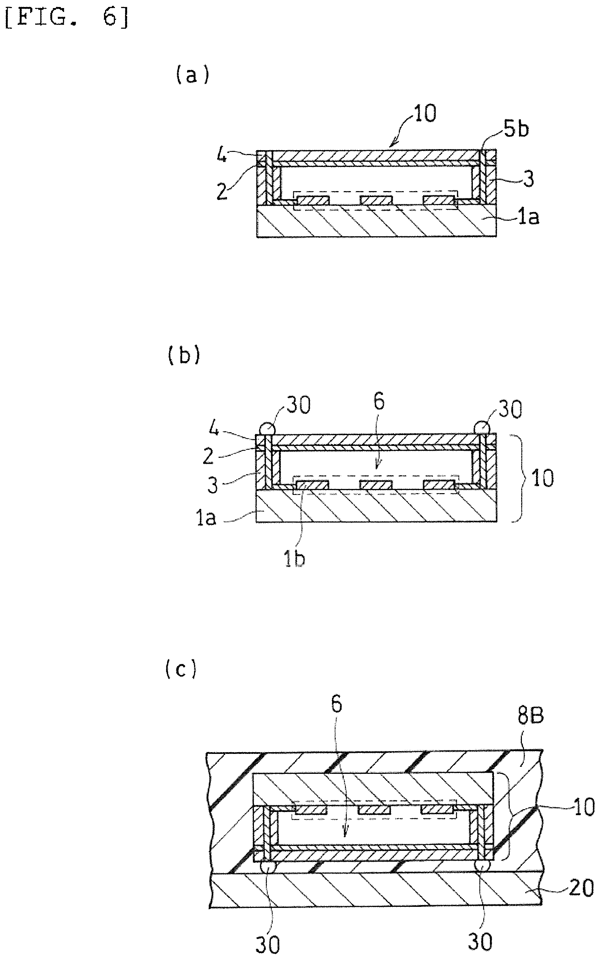

A method for producing a mounting structure is described below, with reference to FIG. 6. FIG. 6 illustrates a production method of the mounting structure of FIG. 4A. The configuration and production method of the mounting structure are not limited thereto.

First, a second circuit member is prepared (FIG. 6(a)). The second circuit member is, for example, the circuit member 10. When the circuit member 10 is encapsulated with the resin encapsulant 8A (see FIGS. 2C and 2D), the resin encapsulant 8A on the principal surface of the piezoelectric body 1a and/or the principal surface of the cover 4 may be removed along each principal surface, to expose the piezoelectric body 1a and/or the cover 4.

Next, at a position on the cover 4 to be electrically connected to the conductor 5, an electrically conductive pad (not shown) for providing the bump 30 thereon, and the bump 30 are formed (FIG. 6(b)). This is not a limitation, and the bump 30 can be formed at a predetermined position of the cover 4 or the first circuit member 20 by a method such as ink jet printing, screen printing, transferring, or plating.

Next, the second circuit member 10 is placed on the first circuit member 20 via the bumps 30, and through subsequent heating and cooling, the second circuit member 10 becomes mounted on the first circuit member 20. When the circuit member 10 is held on the tape material 7 as in FIGS. 2A to 2D, the circuit member 10 is mounted on the first circuit member 20 after the tape material 7 is separated from the circuit member 10. The separation of the tape material 7 10 may be done before the bumps 30 are formed, or after the bumps 30 are formed and before the circuit member 10 is mounted on the first circuit member 20, or after the circuit member 10 is mounted on the first circuit member 20.

When a plurality of the second circuit members 10 are mounted on the first circuit member 20, the second circuit members 10 may be encapsulated by injecting a molding material (resin encapsulant 8B in an uncured or semi-cured state) between the second circuit members 10 and between the cover 4 and the first circuit member 20, and then curing the material (FIG. 6(c)).

The encapsulation method is not limited, and examples thereof are as described above. Preferred among them is transfer molding, in terms of dimensional precision. In transfer molding, when the molding material is injected into the die, the pressure is applied to the cover 4 by the molding material, which tends to deform the space 6. The cover 4, however, includes the sheet S having a high tensile modulus of elasticity. Even though subjected to a high pressure (e.g., 0.1MPa or more, and in view of the productivity, 1 MPa or more, or further, 5MPa or more; the upper limit may be, for example, 20MPa or less, or further 15MPa or less), the cover 4 shows little deformation.

The curing of the molding material is performed for 1 to 15 minutes at a temperature preferably from 50 to 200°C, and more preferably from 100 to 175°C. Post-curing may be performed, if necessary, for 30 minutes to 24 hours at a temperature from 100 to 200°C.

When a plurality of the second circuit members 10 are mounted on the first circuit member 20, after the resin encapsulation, the first circuit member 20 may be diced to separate the individual second circuit members 10, thereby to singulate the mounting structure.

### [Examples]

Next, the present invention is more specifically described by way of Examples. The following Examples, however, should not be interpreted in such a way as to limit the present invention.

### <Example 1>

A SAW chip including a SAW filter (thickness: 200µm, size: 1.4×1.1mm), a rib (Rh: 10µm, Rw: 10µm), and a conductor electrically connected to the interdigitated array electrode on the SAW filer was prepared. The material of the rib was a photosensitive polyimide resin, and the area S encircled by the rib was 1mm².

A stack of a GFRP plate 1 (sheet SP) and a GFRP plate 2 (sheet SP) was prepared as a material of a cover (sheet material). The resins contained in the GFRP plates 1 and 2 were in a semi-cured state. The stack was placed on an end of the rib, with the GFRP plate 1 in contact with the rib. Next, by heating to 70°C under pressure, the stack of the GFRP plates 1 and 2 was allowed to adhere to the end of the rib. This was followed by heating to 180°C, thereby to cure the resins contained in the GFRP plates 1 and 2. A cover (thickness: 45µm, size: 1.0×1.0mm) was thus formed.

The GFRP plate 1 was an epoxy resin sheet reinforced with glass fibers, and had a thickness of 20µm. The tensile elastic modulus Es after curing was 21GPa. The glass transition temperature Tgs after curing of the epoxy resin composition used therein was 188°C.

The GFRP plate2 was an epoxy resin sheet reinforced with glassfibers, and had a thickness of 25µm. The tensile elastic modulus Es after curing was 21GPa. The glass transition temperature Tgs after curing of the epoxy resin composition used therein was 188°C.

The epoxy resin compositions used in the GFRP plates1 and 2 had a composition comprising 60 parts by mass of bisphenol A-type epoxy resin, 40 parts by mass of novolac-type epoxy resin, 28 parts by mass of fused silica, and 8 parts by mass of dicyandiamide-based curing agent.

Six solder balls (bumps) were equally disposed on the cover of the SAW chip by screen printing at positions near the periphery of the cover, the positions where the bump is to be electrically connected to the conductor. A plurality of SAW chips provided with the bumps were placed on a silicon wafer of 5 inches in diameter and 650µm in thickness, and they were subjected to heating and cooling. A mounting structure was thus obtained.

The obtained mounting structure was set in a die, and a molding material (epoxy resin composition) was injected into the die under the conditions of a temperature of 175°C and a pressure of 2MPa, whereby encapsulation by transfer molding was performed. The encapsulated mounting structure was cut so that the cross section of the SAW chip was exposed, and observed under an electron microscope (magnification: 1000×) to check the displacement of the cover.

In the displacement observation, whether the space inside the SAW chip was maintained or not was evaluated and ranked into the following three levels.
Excellent: Little or no displacement of the cover was observed, and the hollow space was maintained.
Good: Slight displacement of the cover was observed, but the hollow space was maintained.
Not Good: Considerable displacement of the cover was observed, and the hollow space not maintained.

The molding material (epoxy resin composition) used here had a composition comprising 80 parts by mass of bisphenol A-type epoxy resin, 20 parts by mass of novolac-type epoxy resin, 46 parts by mass of acid anhydride, 50 parts by mass of fused silica, and 1 part by mass of curing accelerator.

### <Example 2>

A mounting structure was produced and evaluated in the same manner as in Example 1, except that a stack of a GFRP plate 3(sheet SP) and a GFRP plate 4(sheet SP) was used as the material of the cover (sheet material), and the stack was placed on the end of the rib, with the GFRP plate3 in contact with the rib. The evaluation result is shown in Table 1. The resins contained in the GFRP plates3and 4 were in a semi-cured state.

The GFRP plate3 was an epoxy resin sheet reinforced with glass fibers, and had a thickness of 20µm. The tensile elastic modulus Es after curing was 18GPa. The glass transition temperature Tgs after curing of the epoxy resin composition used therein was 188°C.

The GFRP plate4 was an epoxy resin sheet reinforced with glass fibers, and had a thickness of 25µm. The tensile elastic modulus Es after curing was 18GPa, and the glass transition temperature Tgs after curing of the epoxy resin composition used therein was 188°C. The compositions of the epoxy resin compositions used in the GFRP plates3 and 4 were the same as that of the GFRP plate1 (GFRP plate2).

### <Example 3>

A mounting structure was produced and evaluated in the same manner as in Example 1, except that a stack of an adhesion layer (epoxy resin composition) and a GFRP plate 5(sheet SP) was used as the material of the cover (sheet material), and the stack was placed on the end of the rib, with the adhesion layer in contact with the rib. The evaluation result is shown in Table 1. The resin contained in the GFRP plate 5 was in a semi-cured state.

The adhesion layer had a thickness of 5µm. The tensile elastic modulus Ea after curing was 200MPa, and the tensile elastic modulus Ea at room temperature after curing was 8GPa. The glass transition temperature Tga after curing of the epoxy resin composition used therein was 131°C. At temperatures from 25 to 60°C, i.e., under the temperature condition not higher than the Tga, the linear expansion coefficient CTEa after curing was 31 ppm/°C. The storage shear modulus Ga' at 70°C before curing of the epoxy resin composition used therein was 0.193MPa, and the ratio: Ga"/Ga' of the loss shear modulus Ga" to the storage shear modulus Ga' was 0.9289. The adhesion of the sheet material to the rib was performed at 70°C, and the curing of the adhesion layer was performed at 150°C.

The adhesion layer had a composition comprising 100 parts by mass of bisphenol A-type epoxy resin, 68 parts by mass of phenol resin-based curing agent, 173 parts by mass of fused silica (particle diameter D95: 1µm or less, average particle diameter D50: 0.3µm), and 5 parts by mass of curing accelerator.

The GFRP plate5 was an epoxy resin sheet reinforced with glass fibers, and had a thickness of 40µm. The tensile elastic modulus Es after curing was 18GPa. The glass transition temperature Tgs after curing of the epoxy resin composition used therein was 188°C. At temperatures from 25 to 60°C, i.e., under the temperature condition not higher than the Tga, the linear expansion coefficient CTEs after curing was 14ppm/°C. The composition of the epoxy resin composition used in the GFRP plate 5 was the same as that of the GFRP plate1 (GFRP plate2).

### <Example 4>

A mounting structure was produced and evaluated in the same manner as in Example 3, except that a stack of the above adhesion layer and a glass plate (sheet SP) was used as the material of the cover (sheet material), and the stack was placed on the end of the rib, with the adhesion layer in contact with the rib. The evaluation result is shown in Table 1.

The glass plate had a thickness of 35µm. The tensile elastic modulus Es was 73GPa. The linear expansion coefficient CTEs after curing of the epoxy resin used in the adhesion layer at temperatures from 25 to 60°C, i.e., temperatures not higher than Tg (131°C), was 3.8ppm/°C.

### <Example 5>

A mounting structure was produced and evaluated in the same manner as in Example 3, except that a stack of the above adhesion layer and copper foil (sheet SP) was used as the material of the cover (sheet material), and the stack was placed on the end of the rib, with the adhesion layer in contact with the rib. The evaluation result is shown in Table 1. The copper foil had a thickness of 20µm. The tensile elastic modulus Es was 124GPa. The linear expansion coefficient CTEs after curing of the epoxy resin used in the adhesion layer at temperatures from 25 to 60°C, i.e., temperatures not higher than Tg (131°C), was 16.8ppm/°C.

### <Example 6>

A mounting structure was produced and evaluated in the same manner as in Example 4, except that the stack used as the material of the cover (sheet material) further included a resin plate stacked on the glass plate (sheet SP). The resin plate was of a polyimide resin composition, and had a thickness of 10µm. The glass transition temperature Tg after curing was 200°C, and the tensile elastic modulus E at room temperature after curing was 1.0GPa.

### <Example 7>

A mounting structure was produced and evaluated in the same manner as in Example 4, except that the molding material (epoxy resin composition) was injected at a pressure of 8MPa. The evaluation result is shown in Table 1.

### <Comparative Example 1>

A mounting structure was produced and evaluated in the same manner as in Example 1, except that a stack of a polyimide sheet 1 (thickness: 25µm, tensile elastic modulus Es after curing: 3.9GPa, glass transition temperature Tgs after curing: 270°C, in a semi-cured state) and a polyimide sheet 2 (thickness: 20µm, tensile elastic modulus Es after curing: 3.9GPa, glass transition temperature Tgs after curing: 270°C) was used as the material of the cover (sheet material), and the stack was placed on the end of the rib, with the polyimide sheet 1 in contact with the rib. The evaluation result is shown in Table 1.

**[Table 1]**

| | State of space |
|---|---|
| Example 1 | Excellent |
| Example 2 | Excellent |
| Example 3 | Good |
| Example 4 | Excellent |
| Example 5 | Excellent |
| Example 6 | Excellent |
| Example 7 | Excellent |
| Comparative Example 1 | Not Good |

Table 1 shows that when the cover includes the sheet S having a tensile elastic modulus Es at 175°C of 10GPa or more, the space within the circuit member can be maintained.

### [Industrial Applicability]

The present invention is useful when producing a mounting structure which includes a circuit member having a space inside, by encapsulation by a method including transfer molding.

### [Reference Signs List]

1: element; 1a: piezoelectric body; 1b: electrode, 2, 2P: adhesion layer; 3: rib; 4: cover; 4P: sheet material, 5, 5a, 5b, 5b': conductor; 5bₚ: cavity for forming conductor; 6:space; 7: tape material; 8A, 8B: resin encapsulant; 10: circuit member; 17: mask; 20, 20A, 20B: first circuit member; 30, 30A, 30B: bump; 40: bonding wire; 100: mounting structure; 200: circuit member; 212: electrode; 213: rib; 214: cover; 215: conductor; 216: space; 220: wiring board; 230: bump; 240: resin encapsulant

## Claims

1. A circuit member, comprising:
an element having a functional region;
a tabular cover disposed opposite to the functional region; and
a rib formed to surround the functional region, for providing a space between the functional region and the cover,
the cover including a sheet S having a thickness of 100µm or less,
the sheet S having a tensile elastic modulus Es at 175°C of 10GPa or more.

2. The circuit member of claim 1, wherein the tensile elastic modulus Es at 175°C of the sheet S is 20GPa or more.

3. The circuit member of claim 1 or 2, further comprising an adhesion layer A provided on at least part of an abutment surface between the element and the rib, and/or on at least part of an abutment surface between the cover and the rib.

4. The circuit member of claim 3, wherein the adhesion layer A has a tensile elastic modulus Ea at 175°C of 10MPa or more.

5. The circuit member of claim 3 or 4, wherein the adhesion layer A has a glass transition temperature Tga of 80°C or more.

6. The circuit member of any one of claims 3 to 5, wherein the adhesion layer A contains a thermosetting resin in a cured state.

7. The circuit member of any one of claims 3 to 6, wherein:
the adhesion layer A is provided on at least part of the abutment surface between the cover and the rib; and
under a temperaturecondition equal to or lower than the glass transition temperature Tga of the adhesion layer A,
the adhesion layer A has a linear expansion coefficient CTEa of 60ppm/°C or less, and
a difference between the linear expansion coefficient CTEa of the adhesion layer A and a linear expansion coefficient CTEs of the sheet S is 50ppm/°C or less.

8. The circuit member of any one of claims 1 to 7, wherein a material of the sheet S is at least one selected from the group consisting of ceramics, silicon, glass, glass fiber-reinforced resin, and metal.

9. The circuit member of claim 8, wherein the material of the sheet S is the glass.

10. The circuit member of claim 8, wherein the material of the sheet S is the glass fiber-reinforced resin.

11. The circuit member of any one of claims 1 to 10, further comprising a resin encapsulant encapsulating the circuit member.

12. A sheet material for forming the cover of claim 1.

13. The sheet material of claim 12, further comprising an adhesion layer AP.

14. The sheet material of claim 13, wherein the adhesion layer AP contains a thermosetting resin in an uncured or semi-cured state.

15. The sheet material of claim 14, wherein
under a temperature condition equal to or higher than room temperature and equal to or lower than a curing temperature of the adhesion layer AP,
the adhesion layer AP has a storage shear modulus Ga' of 0.05 to 10MPa, and
a ratio: Ga"/Ga' of a loss shear modulus Ga" of the adhesion layer AP to the storage shear modulus Ga' is 0.1 to 2.0.

16. A mounting structure, comprising
a first circuit member, and a second circuit member mounted on the first circuit member,
the second circuit member comprising:
an element having a functional region;
a tabular cover disposed opposite to the functional region; and
a rib formed to surround the functional region, for providing a space between the functional region and the cover,
the cover including a sheet S having a thickness of 100µm or less,
the sheet S having a tensile elastic modulus Es at 175°C of 10GPa or more.

17. The mounting structure of claim 16, further comprising a resin encapsulant encapsulating the second circuit member.

18. A method for producing a mounting structure, comprising steps of:
(i) preparing a first circuit member and a second circuit member; and
(ii) mounting the second circuit member on the first circuit member,
the second circuit member comprising:
an element having a functional region;
a tabular cover disposed opposite to the functional region; and
a rib formed to surround the functional region, for providing a space between the functional region and the cover;
the cover including a sheet S having a thickness of 100µm or less,
the sheet S having a tensile elastic modulus Es at 175°C of 10GPa or more.

19. The method for producing a mounting structure of claim 18, wherein the second circuit member prepared in the step (i) includes a resin encapsulant encapsulating the second circuit member.

20. The method for producing a mounting structure of claim 18 or 19, further comprising a step of: (iii) encapsulating the second circuit member mounted on the first circuit member, with a resin encapsulant.
